# EUROPÄISCHE PATENTSCHRIFT

(11) **EP 1 993 335 B1**
(45) Veröffentlichungstag und Bekanntmachung des Hinweises auf die Patenterteilung: **14.03.2012**
(21) Anmeldenummer: 07009594.8
(22) Anmeldetag: 14.05.2007
(51) Int. Cl.: H05K 3/00, B26F 1/14

(54) **Stanzeinrichtung mit Wechselstempel und variablem Stanzmuster**
Stamping device with exchangeable stamp and variable stamping pattern
Dispositif de poinçonnage doté d'un tampon de changement et d'un modèle de poinçon variable

(43) Veröffentlichungstag der Anmeldung: 19.11.2008
(73) Patentinhaber: Groz-Beckert KG, 72458 Albstadt (DE)
(72) Erfinder: Horn, Kuno, 82362 Nusplingen (DE); Heinemann, Ernst-Viktor, 78603 Requishausen (DE)
(74) Vertreter: Rüger, Barthelt & Abel

(56) Entgegenhaltungen:
- EP-A1- 0 781 635
- EP-A1- 0 993 885
- DE-A1- 10 300 831
- US-B1- 6 622 603

## Beschreibung

Die Erfindung betrifft allgemein eine Stanzeinrichtung und insbesondere eine Stanzeinrichtung, die zum Stanzen von Löchern in Green Sheets (ungebrannten Keramiksubstraten) vorgesehen ist.

Beim Stanzen von Green Sheets ist eine große Anzahl von Löchern in ein Keramiksubstrat einzubringen. Dazu dienen Stanzstempel in entsprechender Anzahl. Die Stanzstempel sind parallel zueinander orientiert und werden gleichzeitig durch das Green Sheet gestoßen. Das Green Sheet liegt dabei auf einer Schnittplatte, die entsprechende Stanzöffnungen aufweist.

Eine solche Stanzeinrichtung ist beispielsweise aus der DE 198 55 578 A1 und der US 6 481 323 B1 bekannt. Die Stanzeinrichtung weist einen unteren und einen oberen Werkzeugteil auf, wobei der untere Werkzeugteil durch die Schnittplatte gebildet wird. Zu dem oberen Werkzeugteil gehört eine Führungsplatte mit Stempelführungen, in denen die Schäfte der Stempel vertikal verschiebbar geführt sind. Jeder Stempel weist einen Kopf auf, der über eine Kupplung mit einer Antriebseinrichtung in Verbindung steht. Die Antriebseinrichtung wird durch einen oder mehrere Antriebe gebildet, die die Kupplungseinrichtung linear auf und ab bewegen, um damit die Stempel zu bewegen.

Sollen Stempel ausgewechselt werden, muss die Antriebseinrichtung abgenommen werden. Dazu wird die Antriebseinheit seitlich verschoben, wodurch die gabelförmigen Kupplungseinrichtungen die Köpfe der Stempel freigeben. Die Stempel werden dabei von einer Trägerplatte aufgenommen, um sie in einer oberen Position zu halten.

Die Ausführung der gabelförmigen Kupplungen und der Verschiebemechanismus zur Bewegung der Antriebsträgerplatte und die Stanzstempel müssen äußerst präzise gearbeitet sein. Die Herstellung und die Toleranzanpassung sind aufwendig und kostenintensiv. Toleranzschwankungen und ein nicht sachgemäßes Verschieben der Kupplungsteile kann zu Beschädigungen bzw. zum Zerstören der Stanzstempel führen.

Die EP 0 993 885 A1 offenbart eine Stanzapparatur mit Stanzstempeln, die gruppenweise in Leisten gefasst sind. Die Leisten sind in dem Oberwerkzeug angeordnet und mit diesem verschraubt. Dadurch sind sie bei Bedarf auswechselbar. Alle mit dem Oberwerkzeug verbundenen Stanzstempel führen den Stanzhub des Oberwerkzeugs gemeinsam aus.

Davon ausgehend ist es Aufgabe der Erfindung, eine Stanzvorrichtung zu schaffen, die eine Stempelauswahl gestattet.

Die erfindungsgemäße Stanzeinrichtung weist einen oberen

Werkzeugteil und einen unteren Werkzeugteil auf. Letzterer enthält eine Schnittplatte mit einer Anzahl von Stanzöffnungen. Diese Stanzöffnungen können in so genannten Schnittbuchsen angeordnet sein, die Teil der Schnittplatte sein können. Der obere Werkzeugteil oder Teile desselben werden auf den unteren Werkzeugteil zu und von diesem weg bewegt. Die Stanzstempel lassen sich dabei aktivieren und deaktivieren, um den Stanzhub zu vollführen oder passiv zu bleiben. Dazu sind die Stanzstempel in zumindest zwei Gruppen eingeteilt, wobei mehrere Stanzstempel der einen Gruppe in zumindest einem Halteteil und mehrere Stanzstempel der anderen Gruppe in zumindest einem anderen Halteteil angeordnet sind. Den Halteteilen und Stanzstempeln ist ein Betätigungselement, vorzugsweise in Form einer Platte zugeordnet, die der Auswahl derjenigen Halteelemente und Stanzstempel dient, die den Stanzhub vollführen sollen. Diese Auswahlplatte ist vorzugsweise quer zur Stanzrichtung verschiebbar gelagert, wobei zumindest zwei, vorzugsweise mehrere Verschiebepositionen gezielt ausgewählt werden können. Dazu kann ein geeigneter Verschiebeantrieb, beispielsweise in Form eines Pneumatikantriebs dienen.

Die Halteelemente sind vorzugsweise Stempelhalteleisten mit Öffnungen, die in einer Reihe angeordnet sind. Die Öffnungen dienen zur Aufnahme der Stanzstempel. Vorzugsweise befinden sich die Köpfe der Stanzstempel in diesen Öffnungen. Die verschiedenen Stempelhalteleisten sind vorzugsweise parallel zueinander orientiert und mit einem geeigneten Federmittel, beispielsweise Druckfedern, gegen Anschläge einer Führungsplatte vorgespannt. Die Auswahlplatte ist mit den Halteleisten in und außer Eingriff überführbar. Dazu sindvorzugsweise entsprechende Koppelmittel vorgesehen. Die Koppelmittel sind vorzugsweise dazu vorgesehen, zwischen den Halteleisten und der Auswahlplatte eine formschlüssige Verbindung herzustellen oder zu lösen. Die formschlüssige Verbindung kann geschaffen werden, indem die Halteleisten mit Koppelausnehmungen versehen sind, in die Vorsprünge der Auswahlplatte ein und aus gefahren werden können. Vorsprünge der Auswahlplatte werden z.B. durch Randabschnitte derselben gebildet, die in Koppelausnehmungen quer zur Stanzrichtung ein- und ausgefahren werden können. Die Koppelmittel können auch anders herum - Koppelausnehmungen an der Auswahlplatte und Vorsprünge an den Halteleisten - vorgesehen sein.

Durch das Verschieben der Auswahlplatte können einzelne Stempelhalteleisten aktiviert oder deaktiviert werden, d.h. sie nehmen am Stanzhub teil oder lassen diesen aus. Außerdem kann die Auswahlplatte im Ganzen abgenommen werden, um Zugang zu den Halteleisten und den darin gelagerten Stempeln zu gewähren. Auf diese Weise können die Stanzstempel auf einfache Weise ausgewechselt oder gewartet werden. Dies verlangt weder besondere Fingerfertigkeit noch Ausbildung. Beim Abnehmen oder Aufsetzen der Antriebseinrichtung auf den oberen Werkzeugteil werden Kupplungsverbindungen nicht wie beim Stand der Technik zwischen den Stempeln und der Antriebseinrichtung sondern zwischen den Stempelhalteleisten und der Auswahlplatte hergestellt bzw. gelöst. Diese Verbindung ist hinsichtlich der erforderlichen Fertigungsgenauigkeit und -toleranzen weseitlich weniger anspruchsvoll als im Stand der Technik. Außerdem ist die Gefahr der Stempelbeschädigung gebannt.

Weitere Einzelheiten vorteilhafter Ausführungsformen der Erfindung ergeben sich aus der Zeichnung, der Beschreibung oder Ansprüchen. Die Beschreibung ist auf wesentliche Aspekte der Erfindung und sonstiger Gegebenheiten beschränkt. Die Zeichnung offenbart weitere Einzelheiten und ergänzt die Beschreibung.

Es zeigen:
Figur 1 eine Stanzeinrichtung in schematisierter Darstellung in Seitenansicht,
Figur 2 die Stanzeinrichtung nach Figur 1 in perspektivischer, teilweise aufgeschnittener Explosionsdarstellung,
Figur 3 bis 6 die Stanzeinrichtung nach Figur 1 und 2 in Vertikalschnittdarstellung in verschiedenen Betriebs- und Arbeitspositionen und
Figur 7 bis 9 die Stanzeinrichtung nach Figur 1 und 2 in ausschnittsweiser Draufsicht in verschiedenen Betriebspositionen.

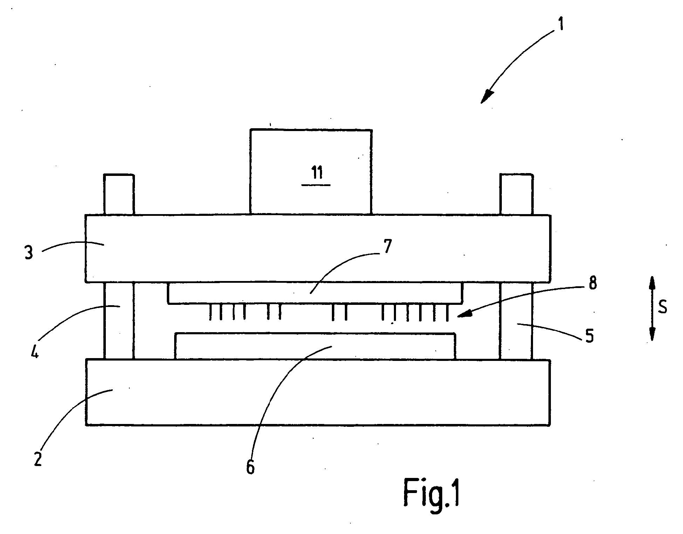

In Figur 1 ist eine Stanzeinrichtung 1 veranschaulicht, die dazu dient, in einem flachen Gegenstand, wie beispielsweise einem Green Sheet, ein vorgegebenes Lochmuster zu erzeugen. Unter Green Sheets werden ungebrannte Keramiksubstrate verstanden, wie sie beispielsweise zur Herstellung keramischer Träger, die elektronische Schaltungen aufweisen, Anwendung finden.

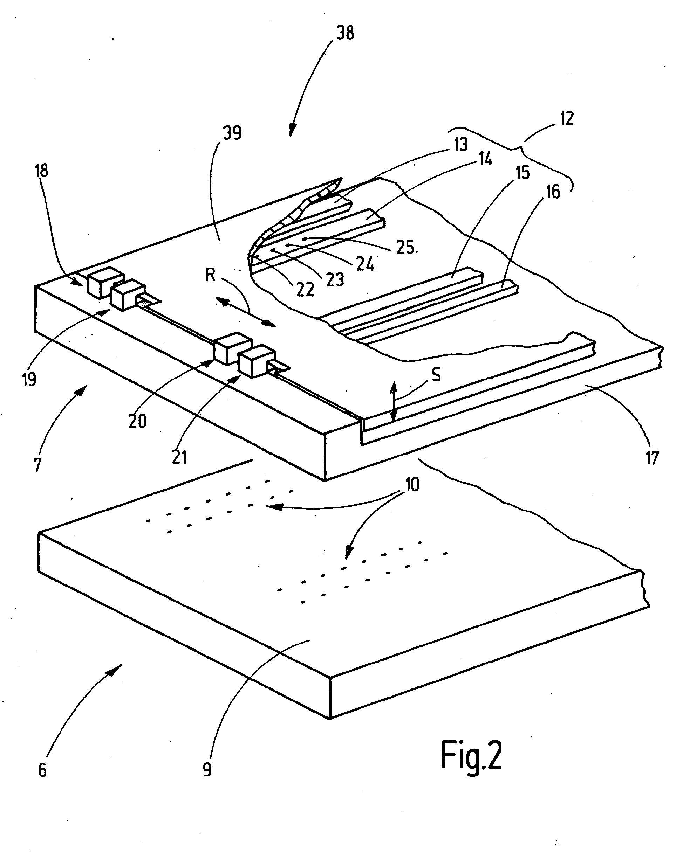

Die Stanzeinrichtung 1 weist einen äußeren Rahmen mit einem Rahmenunterteil 2, einem Rahmenoberteil 3 und Führungen 4, 5 auf. Der Rahmenunterteil 2 trägt einen unteren Werkzeugteil 6. Der Rahmenoberteil 3 trägt einen oberen Werkzeugteil 7. Der obere Werkzeugteil 7 ist mit einer Anzahl Stempel 8 versehen, die parallel zueinander orientiert sind und zu dem unteren Werkzeugteil 6 weisen. Der untere Werkzeugteil 6 trägt eine Schnittplatte 9, wie sie aus Figur 2 ersichtlich ist. Sie ist mit einer Anzahl von Stanzöffnungen 10 versehen, in die die Stempel 8 eintauchen können, wenn sie das Werkstück durchdrungen haben. Die Stanzöffnungen können in (nicht dargestellten) Schnittbuchsen enthalten sein.

Das Rahmenoberteil 3 und/oder der obere Werkzeugteil 7 ist mit mindestens einer Antriebseinrichtung 11 verbunden, die dazu dient, die Stempel 8 auf und ab zu bewegen. Die Antriebseinrichtung kann eine mechanische, eine elektrische oder eine pneumatische oder eine hydraulische Antriebseinrichtung sein.

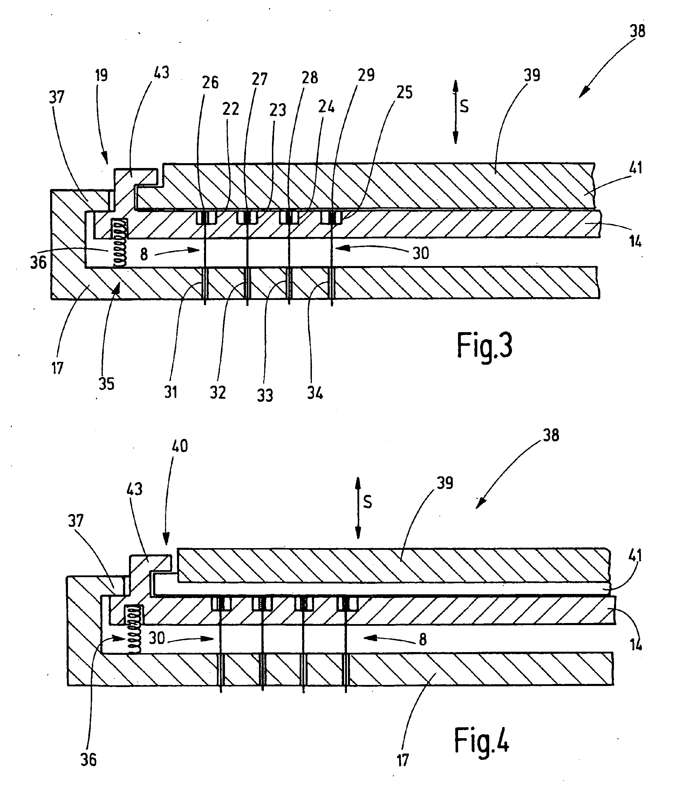

Wie Figur 2 weiter zeigt, gehören zu dem oberen Werkzeugteil 7 mehrere Halteelemente 12 in Form von Stempelhalteleisten 13, 14, 15, 16, in denen die Stempel 8 gehalten sind. Die Stempelhalteleisten 13 bis 16 sind in einer Führungsplatte 17 gefasst, in der sie wenigstens um den Stanzhub in Stanzrichtung S bewegbar sind. Die Stanzrichtung S stimmt mit der Längsrichtung der Stempel 8 überein. Die länglichen Stempelhalteleisten 13 bis 16 sind mit ihren Enden 18, 19, 20, 21 in entsprechenden Aussparungen der Führungsplatte 17 geführt. Jede Stempelhalteleiste 13 bis 16 weist eine Reihe von Öffnungen 22, 23, 24, 25 (siehe auch Figur 3 bis 6) auf, die der Aufnahme von Stempelköpfen 26, 27, 28, 29 dienen.

Die nachfolgende Beschreibung der Stempelhalteleiste 14, insbesondere mit Bezug auf die Figuren 3 bis 6, steht stellvertretend für die anderen Stempelhalteleisten 13, 15, 16 sowie etwaige weitere nicht dargestellte Stempelhalteleisten, die untereinander vorzugsweise einheitlich ausgebildet sind.

Die Stempelhalteleiste 14 weist im Anschluss an die Öffnungen 22 bis 25 Durchgangsbohrungen geringeren Durchmessers auf, durch die sich der jeweilige Schaft 30 jedes Stempels 8 erstreckt. Der gerade zylindrische Schaft 30 ragt dabei durch entsprechende Führungsbohrungen 31, 32, 33, 34, die in der Führungsplatte 17 ausgebildet sind. Die Führungsbohrungen 31 bis 34 können mit einer Führungsbuchse versehen sein, die den Schaft 30 an seiner äußeren Mantelfläche oder an einem Zwischenabschnitt mit geringerem Durchmesser fasst und führt. Die Höhe der Führungsbuchse kann mit der Länge der Führungsbohrung übereinstimmen, kann aber auch davon abweichen.
Zur präzisen Führung des Schafts 30 eines Stanzstempels 8 können mehrere Führungsbuchsen vorgesehen sein, die sich jeweils über die Gesamtlänge des Stanzstempels erstrecken.

Zwischen der Führungsplatte 17 und der Stempelhalteleiste 14 wirkt ein Federmittel 35, um die Stempelhalteleiste 14 von der Führungsplatte 17 weg vorzuspannen. Das Federmittel 35 umfasst im vorliegenden Ausführungsbeispiel jeweils wenigstens eine, vorzugsweise zwei an den Enden der Stempelhalteleiste 14 angeordnete Druckfedern 36. Das Federmittel 35 spannt das Ende 19 der Halteleiste 14 gegen einen Anschlag 37 vor, der an der Führungsplatte 17 ausgebildet ist und das Ende 19 der Stempelhalteleiste 14 übergreift, wie es in Figur 3 dargestellt ist. Das gegenüber liegende in Figur 3 nicht veranschaulichte Ende der Stempelhalteleiste 14 ist ebenso gefasst und ausgebildet.

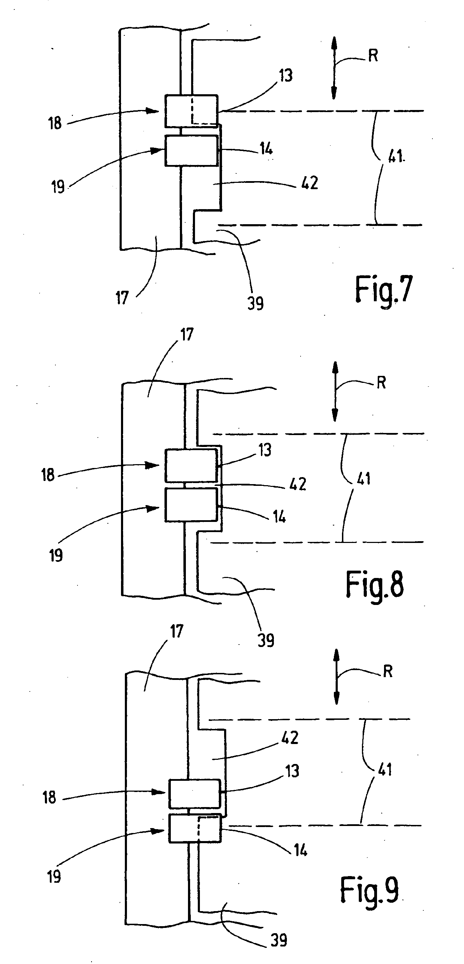

Den Stempelhalteleisten 13 bis 16 ist ein Auswahlelement 38, hier in Form einer Auswahlplatte 39, zugeordnet, die die Halteleisten 13 bis 16 überdeckt. Die Auswahlplatte 39 ist, wie Figur 2 veranschaulicht, quer zu der Stanzrichtung S im vorliegenden Ausführungsbeispiel horizontal in einer Auswahlrichtung R verschiebbar. Sie wirkt dabei mit der Stempelhalteleiste 14 wie auch mit den anderen Stempelhalteleisten 13, 15, 16 über ein Koppelmittel 40 zusammen. Zu diesem gehören, wie in Figur 3 und 4 anhand der Stempelhalteleiste 14 veranschaulicht, eine Druckleiste in Form einer Rippe 41, die an derjenigen Seite der Auswahlplatte 39 angeordnet ist, die der Stempelhalteleiste 14 zugeordnet ist. Die Rippe 41 und die Auswahlplatte 39 können einstückig, nahtlos aus einem Stück gebildet sein. Die Rippe 41 kann auch als separate Leiste gebildet sein und dann mit der Auswahlplatte mit bekannten Verbindungsmitteln (Schrauben, Kleben, Schweißen, etc.) verbunden sein. Die Rippe 41 steht je nach Auswahlposition der Auswahlplatte 39 genau oberhalb einer der Stempelhalteleisten (Figur 3) oder neben Stempelhalteleisten 13, 14 (Figur 4). Außerdem gehört zu dem Koppelmittel ein an der Platte 39 ausgebildeter Rand, der gerade ausgebildet ist und sich in Auswahlrichtung R erstreckt. Der Rand weist Ausnehmungen auf, wie z.B. die Figuren 7 bis 9 anhand einer Ausnehmung 42 zeigen, die den Stempelhalteleisten 13, 14 zugeordnet ist. Die Ausnehmung 42 bildet einen Randausschnitt der Auswahlplatte 39. Sie ist etwa zentrisch zwischen z.B. zwei in den Figuren 7 bis 9 gestrichelt eingetragenen Rippen 41 angeordnet. Die Breite der Ausnehmung 42 ist, wie Figur 8 zeigt, so groß bemessen, dass die beiden Stempelhalteleisten 13, 14 in sie passen. Jede Stempelhalteleiste 13, 14 hat, wie insbesondere die Figuren 3 bis 6 zeigen, an ihrem jeweiligen Ende 19 zumindest optional einen den Rand der Auswahlplatte 39 übergreifenden Fortsatz 43 mittels dessen die Stempelhalteleiste 14 in Stanzrichtung S fest an die Auswahlplatte 39 gekoppelt werden kann.

Die insoweit beschriebene Stanzeinrichtung 1 arbeitet wie folgt:

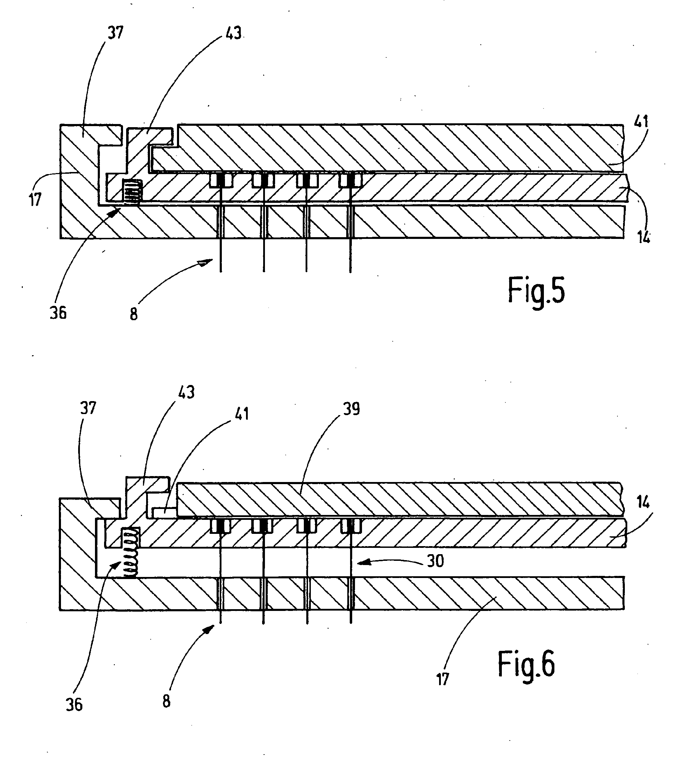

Zum Ausführen von Stanzarbeiten werden die Stempel 8 in Stanzrichtung S bewegt. Um festzulegen, welche der Stempel 8 diese Bewegung ausführen, wird die Auswahlplatte 39 in eine der Positionen nach Figur 7 oder 9 überführt. Damit ist entweder die Stempelhalteleiste 13 (Figur 7) oder die Stempelhalteleiste 14 (Figur 9) an die Auswahlplatte 39 gekoppelt. Wie Figur 3 veranschaulicht, überdeckt die Rippe 41 dabei die Stempelhalteleiste 14. Wenn die Auswahlplatte 39 nun zur Durchführung eines Stanzhubs nach unten bewegt wird, drückt die Rippe 41, wie Figur 5 zeigt, die Stempelhalteleiste 14 nach unten, wodurch die Stempel 8 einen Stanzhub ausführen. Dies erfolgt gegen die Kraft der Druckfeder 36. Die Führungsplatte 17 kann dabei in Ruhe bleiben.

Wird die Auswahlplatte 39 hingegen in die Position nach Figur 7 (entsprechend Figur 4) verfahren, steht das Ende 19 der Stempelhalteleiste 14 innerhalb der Ausnehmung 42. Die Rippe 41 steht neben der Stempelhalteleiste 14. Somit ist in Stanzrichtung S keine Kopplung zwischen der Auswahlplatte 39 und der Stempelhalteleiste 14 vorhanden. Wenn die Auswahlplatte 39 nun ihren Stanzhub vollführt, bleiben die Stempel 8 in ihrer oberen Position. Die Druckfeder 36 drückt die Stempelhalteleiste 14 von unten her an den Anschlag 37. Wie Figur 6 veranschaulicht, taucht die Rippe 41 in einen neben der Stempelhalteleiste 14 vorhandenen Raum und betätigt die Stempelhalteleiste 14 nicht.

Somit kann durch Verschieben der Auswahlplatte 39 zwischen den Positionen nach Figur 7 und Figur 9 eine der Stempelhalteleisten 13, 14 aktiviert und die andere deaktiviert werden. Entsprechendes gilt für die Stempelhalteleisten 15, 16. In diesem Sinne werden die Koppelmittel 40 der Stempelhalteleisten 13, 14 gegensinnig betätigt, d.h. während eines gekoppelt ist, ist das jeweils andere entkoppelt.

Wird die Auswahlplatte 39 in eine Mittelposition verfahren, betätigt sie keine der Stempelhalteleisten 13, 14, 15, 16. Sie kann in diesem Zustand abgenommen und entfernt werden, wobei die Köpfe der Stempel 8 frei liegen. Es können einzelne Stempel einfach ohne großen Aufwand oder die Stempelhalteleisten 13, 14 mit allen Stempeln ausgewechselt werden.

Erfindungsgemäß wird an einer Stanzeinrichtung 1 eine Auswahlplatte 39 vorgesehen, die einzelne Stempelhalteleisten 13, 14, 15, 16 aktiviert oder deaktiviert. Sie hat dazu Koppelmittel 40, zu denen beispielsweise eine formschlüssige Kupplung zwischen einer Stempelhalteleiste 13, 14 und der Auswahlplatte 39 gehören. Zu der formschlüssigen Kupplung kann ein mit einer Ausnehmung 42 versehener Rand der Auswahlplatte 39, ein diesen Rand übergreifender Fortsatz 43 der Stempelhalteleiste 13, 14 und/oder eine Rippe 41 gehören, die an der Unterseite der Auswahlplatte 39 angeordnet und der Stempelhalteleiste 13, 14 zugeordnet ist. Dadurch kann wahlweise ein Formschluss zwischen der Stempelhalteleiste 13, 14 und der Auswahlplatte 39 hergestellt oder beseitigt werden. Mittels der Rippe 41 wird der Stanzhub der Auswahlplatte 39 lediglich auf diejenige Stempelhalteleiste 13 oder 14 übertragen, die formschlüssig mit dem seitlichen Rand oder Vorsprüngen der Auswahlplatte 39 in Eingriff steht. Die längliche Rippe 41 deckt die Köpfe 26, 27, 28, 29 der Stempel 8 ab und überträgt den Hub flächenhaft auf die Stempelhalteleiste 13 oder 14.

### Bezugszeichen

- 1: Stanzeinrichtung
- 2: Rahmenunterteil
- 3: Rahmenoberteil
- 4, 5: Führungen
- 6: unterer Werkzeugteil
- 7: oberer Werkzeugteil
- 8: Stempel
- 9: Schnittplatte
- 10: Stanzöffnungen
- 11: Antriebseinrichtung
- 12: Halteelemente
- 13, 14, 15, 16: Stempelhalteleisten
- 17: Führungsplatte
- S: Stanzrichtung
- 18, 19, 20, 21: Enden
- 22, 23, 24, 25: Öffnungen
- 26, 27, 28, 29: Stempelköpfe
- 30: Schaft
- 31, 32, 33, 34: Führungsbohrung
- 35: Federmittel
- 36: Druckfeder
- 37: Anschlag
- 38: Betätigungselement, Auswahlelement
- 39: Auswahlplatte
- R: Auswahlrichtung
- 40: Koppelmittel
- 41: Rippe, Druckleiste
- 42: Ausnehmung
- 43: Fortsatz

## Patentansprüche

1. Stanzeinrichtung (1) insbesondere zum Stanzen von Green Sheets
mit einem unteren Werkzeugteil (6), der eine Schnittplatte (9) mit einer Anzahl von Stanzöffnungen (10) aufweist,
mit einem oberen Werkzeugteil (7), das relativ zu dem unteren Werkzeugteil (6) auf dieses zu und von diesem weg beweglich gelagert ist,
mit mehreren Stanzstempeln (8), die dem oberen Werkzeugteil (7) zugeordnet sind,
mit mindestens zwei Halteelementen (12), die an dem oberen Werkzeugteil (7) in Stanzrichtung (S) beweglich angeordnet sind und in denen die Stanzstempel (8) gruppenweise gelagert sind, und
mit einem Betätigungselement (38), das an dem oberen Werkzeugteil (7) gelagert ist, um die Halteelemente (12) bei einem Stanzhub in Stanzrichtung (S) zu bewegen,
**dadurch gekennzeichnet, dass**
an den Halteelementen (12) und dem Auswahlelement (38) Koppelmittel (40) vorgesehen sind, um die Halteelemente (12) und das Betätigungselement (38) wahlweise miteinander zu koppeln oder die Koppelverbindung freizugeben.

2. Stanzeinrichtung nach Anspruch 1, **dadurch gekennzeichnet, dass** die Halteelemente (12) durch Stempelhalteleisten (13, 14) gebildet werden, die sich quer zu den parallel zueinander gehaltenen Stanzstempeln (8) erstrecken und die Öffnungen (22, 23, 24, 25) aufweisen, in denen die Stanzstempel (8) gehalten sind.

3. Stanzeinrichtung nach Anspruch 2, **dadurch gekennzeichnet, dass** die Öffnungen (22, 23, 24, 25) in einer Reihe angeordnet sind.

4. Stanzeinrichtung nach Anspruch 1, **dadurch gekennzeichnet, dass** die Halteelemente (12) durch ein Federmittel (35) gegen zumindest einen Anschlag (37) des oberen Werkzeugteils (7) vorgespannt sind.

5. Stanzeinrichtung nach Anspruch 1, **dadurch gekennzeichnet, dass** das Betätigungselement (38) eine Auswahlplatte (39) ist, die mit den Halteelementen (12) in und außer Eingriff überführbar ist.

6. Stanzeinrichtung nach Anspruch 1, **dadurch gekennzeichnet, dass** die Halteelemente (12) in zwei Gruppen unterteilt sind, wobei die Koppelmittel (40) der beiden Gruppen bezüglich ihrer Koppelstellung und Freigabestellung gegensinnig ausgebildet sind.

7. Stanzeinrichtung nach Anspruch 6, **dadurch gekennzeichnet, dass** das Auswahlelement (38) eine Freigabestellung aufweist, in der die Halteelemente (12) beider Gruppen in Freigabestellung stehen.

8. Stanzeinrichtung nach Anspruch 1, **dadurch gekennzeichnet, dass** zu den Koppelmitteln (40) Druckleisten (41) gehören, die an dem Betätigungselement (38) an einer dem Halteelement (12) zugewandten Seite angeordnet sind, um die Stanzbewegung auf das Halteelement (12) zu übertragen, wenn das Betätigungselement (38) in Koppelstellung steht.

9. Stanzeinrichtung nach Anspruch 1, **dadurch gekennzeichnet, dass** das Auswahlelement (38) quer zu den Halteelementen (12) verschiebbar gelagert ist.

## Claims

1. Punching device (1) in particular for punching green sheets
with a lower tool part (6), which has a cutting die (9) with a number of punch openings (10),
with an upper tool part (7), which is mounted to be movable relative to the lower tool part (6) towards and away therefrom,
with multiple punches (8) associated with the upper tool part (7),
with at least two holding elements (12), which are arranged on the upper tool part (7) to be movable in the punching direction (S) and in which the punches (8) are mounted in groups, and
with an operating element (38), which is mounted on the upper tool part (7) to move the holding elements (12) during a punching stroke in punching direction (S), **characterised in that**
coupling elements (40) are provided on the holding elements (12) and the selector element (38) to selectively couple the holding elements (12) and the operating element (38) to one another or to release the coupling connection.

2. Punching device according to claim 1, **characterised in that** the holding elements (12) are formed by punch holding bars (13, 14), which extend transversely to the punches (8) held parallel to one another and have openings (22, 23, 24, 25), in which the punches (8) are held.

3. Punching device according to claim 2, **characterised in that** the openings (22, 23, 24, 25) are arranged in a row.

4. Punching device according to claim 1, **characterised in that** the holding elements (12) are biased by a spring element (35) against at least one stop (37) of the upper tool part (7).

5. Punching device according to claim 1, **characterised in that** the operating element (38) is a selector plate (39), which can be moved into and out of engagement with the holding elements (12).

6. Punching device according to claim 1, **characterised in that** the holding elements (12) are divided into two groups, wherein the coupling elements (40) of the two groups are configured in opposing directions with respect to their coupling position and release position.

7. Punching device according to claim 6, **characterised in that** the selector element (38) has a release position, in which the holding elements (12) of both groups stand in release position.

8. Punching device according to claim 1, **characterised in that** the coupling elements (40) include pressure bars (41) arranged on the operating element (38) on a side facing the holding element (12) in order to transmit the punching movement to the holding element (12) when the operating element (38) stands in coupling position.

9. Punching device according to claim 1, **characterised in that** the selector element (38) is mounted to be displaceable transversely to the holding elements (12).

## Revendications

1. Dispositif de poinçonnage (1), en particulier pour le poinçonnage de feuilles vertes,
comprenant une partie d'outil inférieure (6) qui présente une matrice de découpage (9) avec un certain nombre d'orifices de poinçonnage (10),
comprenant une partie d'outil supérieure (7) qui est disposée par rapport à la partie d'outil inférieure (6) de manière à pouvoir être rapprochée et éloignée de celle-ci,
comprenant plusieurs poinçons (8) qui sont associés à la partie d'outil supérieure (7),
comprenant au moins deux éléments de support (12) qui sont disposés sur la partie d'outil supérieure (7) avec possibilité de déplacement dans la direction de poinçonnage (S), et dans lesquels les poinçons (8) sont montés par groupes, et
comprenant un élément d'actionnement (38) qui est monté sur la partie d'outil supérieure (7) pour déplacer les éléments de support (12) dans la direction de poinçonnage (S) lors d'une course de poinçonnage,
**caractérisé en ce que**
des moyens d'accouplement (40) sont prévus sur les éléments de support (12) et l'élément de sélection (38), afin d'accoupler au choix les éléments de support (12) et l'élément d'actionnement (38) ou de libérer la liaison d'accouplement.

2. Dispositif de poinçonnage selon la revendication 1, **caractérisé en ce que** les éléments de support (12) sont composés de baguettes porte-poinçons (13, 14) qui s'étendent perpendiculairement aux poinçons (8) supportés parallèlement les uns aux autres, et qui présentent des ouvertures (22, 23, 24, 25) dans lesquelles sont tenus les poinçons (8).

3. Dispositif de poinçonnage selon la revendication 2, **caractérisé en ce que** les ouvertures (22, 23, 24, 25) sont disposées en une rangée.

4. Dispositif de poinçonnage selon la revendication 1, **caractérisé en ce que** les éléments de support (12) sont mis sous précontrainte par un moyen faisant ressort (35) contre au moins une butée (37) de la partie d'outil supérieure (7).

5. Dispositif de poinçonnage selon la revendication 1, **caractérisé en ce que** l'élément d'actionnement (38) est une plaque de sélection (39) qui peut être amenée en prise et hors de prise d'avec les éléments de support (12).

6. Dispositif de poinçonnage selon la revendication 1, **caractérisé en ce que** les éléments de support (12) sont divisés en deux groupes, les moyens d'accouplement (40) des deux groupes étant réalisés dans des sens opposés concernant leur position d'accouplement et leur position de libération.

7. Dispositif de poinçonnage selon la revendication 6, **caractérisé en ce que** l'élément de sélection (38) présente une position de libération dans laquelle les éléments de support (12) des deux groupes occupent la position de libération.

8. Dispositif de poinçonnage selon la revendication 1, **caractérisé en ce que** les moyens d'accouplement (40) englobent des baguettes de pression (41) qui sont disposées sur l'élément d'actionnement (38), sur un côté tourné vers l'élément de support (12), afin de transmettre le mouvement de poinçonnage à l'élément de support (12), lorsque l'élément d'actionnement (38) est en position d'accouplement.

9. Dispositif de poinçonnage selon la revendication 1, **caractérisé en ce que** l'élément de sélection (38) est monté de manière à pouvoir être déplacé perpendiculairement aux éléments de support (12).
